(19) **Europäisches Patentamt**

**European Patent Office**

**Office européen des brevets**

(11) **EP 0 953 228 B1**

(12) **FASCICULE DE BREVET EUROPEEN**

(45) Date de publication et mention
de la délivrance du brevet:
**28.08.2002  Bulletin 2002/35**

(51) Int Cl.⁷: **H03K 17/96**

(21) Numéro de dépôt: **98902080.5**

(22) Date de dépôt: **16.01.1998**

(86) Numéro de dépôt international:
**PCT/FR98/00079**

(87) Numéro de publication internationale:
**WO 98/032227 (23.07.1998 Gazette 1998/29)**

(54) **DISPOSITIF DE COMMANDE A TOUCHES SENSITIVES**

BERÜHRUNGSEMPFINDLICHE STEUERUNGSVORRICHTUNG

CONTROL DEVICE WITH SENSITIVE KEYS

(84) Etats contractants désignés:
**CH DE DK ES FR GB IT LI NL SE**

(30) Priorité: **16.01.1997  FR 9700416**

(43) Date de publication de la demande:
**03.11.1999  Bulletin 1999/44**

(73) Titulaire: **Brandt Cooking**
**45140 Saint Jean de la Ruelle (FR)**

(72) Inventeurs:
• **CORNEC, René, Thomson-CSF S.C.P.I.**
**F-94117 Arcueil Cedex (FR)**

• **GOUARDO, Didier, Thomson-CSF S.C.P.I.**
**F-94117 Arcueil Cedex (FR)**
• **YVE, Christophe, Thomson-CSF S.C.P.I.**
**F-94117 Arcueil Cedex (FR)**

(74) Mandataire: **Rinuy, Santarelli**
**14, avenue de la Grande Armée**
**75017 Paris (FR)**

(56) Documents cités:
**EP-A- 0 544 483          EP-A- 0 668 657**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

**Description**

La présente invention se rapporte un dispositif de commande à touche sensitive.

Les dispositifs de commande à touche sensitive comportent au moins une touche à effet capacitif reliée à un circuit électronique comprenant essentiellement un générateur de tension sinusoïdale relié via la touche et un redresseur à une entrée d'un comparateur dont l'autre entrée reçoit une tension de référence continue. Ce comparateur délivre un signal à deux états respectivement caractéristiques de l'activation (attouchement) et de la non-activation de la touche par un utilisateur. Le principe de détection de l'attouchement est la détection de l'augmentation de la capacité de la touche lorsque l'utilisateur en approche son doigt. Cette augmentation est faible : en général 10 à 20 %. Elle est difficile à détecter du fait que la capacité de la touche est faible : environ 3 pF. A l'attouchement, elle augmente jusqu'à une valeur d'environ 3,3 à 3,6 pF. La production du signal de détection peut être décomposée en trois phases :

-   génération du signal alternatif d'excitation de la capacité de la touche,
-   détection de la valeur crête du signal aux bornes du condensateur constitué par la touche,
-   comparaison de cette valeur crête avec un signal de référence et production du signal de détection d'attouchement.

Comme précisé ci-dessus, du fait de la faible valeur initiale de la capacité de la touche et de sa faible variation, la phase de détection de valeur crête est de mise en oeuvre délicate. Il en résulte que les deux autres phases le sont également. En effet, cette phase de détection d'attouchement est généralement réalisée à l'aide d'une diode de redressement. La capacité intrinsèque de la diode constitue une capacité parasite qui nuit à la qualité de la détection. Pour réaliser la phase de comparaison, il faut produire un signal de détection de valeur crête de forte amplitude, afin de rendre négligeable la chute de tension directe aux bornes de la diode. Il faut que le signal d'excitation soit un signal sinusoïdal le plus pur possible afin que les effets de la capacité parasite de la diode (d'environ 1 à 2 pF) ne perturbent pas la détection de l'attouchement. Ce signal doit aussi présenter une forme constante pour ne pas modifier la sensibilité de la touche, du fait que la capacité de la touche intègre le signal. En outre, la valeur crête de ce signal doit être stable pour ne pas modifier la sensibilité de la touche. En particulier, il doit être stable en température, ce qui nécessite un circuit générateur coûteux, condition incompatible avec les impératifs d'une production en grande série. De plus, un tel circuit générateur est encombrant, ce qui est un inconvénient dans certaines applications. Un dispositif de commande selon le préambule de la revendication 1 est connu par exemple d'après EP -A-O 668 657.

La présente invention a pour objet un dispositif de commande à au moins une touche capacitive qui ne nécessite pas de générateur de tension alternative coûteux et/ou encombrant, dont la sensibilité et la reproductibilité ne dépendent pas, ou très peu, des variations de l'amplitude et de la forme de la tension alternative ou des variations de la température des composants de ce dispositif, et qui soit le moins onéreux possible.

Le dispositif de commande conforme à l'invention est décrit dans la revendication 1. Ce dispositif est alimenté par un générateur de signal périodique, de préférence à valeur moyenne non nulle, avantageusement un signal rectangulaire, produit par exemple par un microprocesseur, dont le rapport cyclique peut être variable, ce générateur étant relié à une première entrée d'un comparateur par l'intermédiaire d'un circuit détecteur à deux diodes appairées en série et en opposition, associées à un pont diviseur résistif, relié entre la première entrée du comparateur et une borne de référence, le point commun des deux résistances du pont diviseur étant relié au point commun des deux diodes, ce dernier étant relié à la touche sensitive, ce générateur étant par ailleurs relié à la deuxième entrée du comparateur par un circuit intégrateur.

De façon avantageuse, les deux diodes font partie d'un même circuit intégré dit "monochip", tel que le circuit BAV 70 ou BAW 56.

La présente invention sera mieux comprise à la lecture de la description détaillée de deux modes de réalisation, pris à titre d'exemples non limitatifs et illustrés par le dessin annexé, sur lequel :

-   la figure 1 est un schéma d'un dispositif de commande conforme à l'invention, utilisant une paire de diodes à cathode commune,
-   la figure 2 est un diagramme de forme d'onde relevée dans le dispositif de la figure 1, et
-   la figure 3 est un schéma d'une variante du dispositif de commande conforme à l'invention, utilisant une paire de diodes à anode commune.

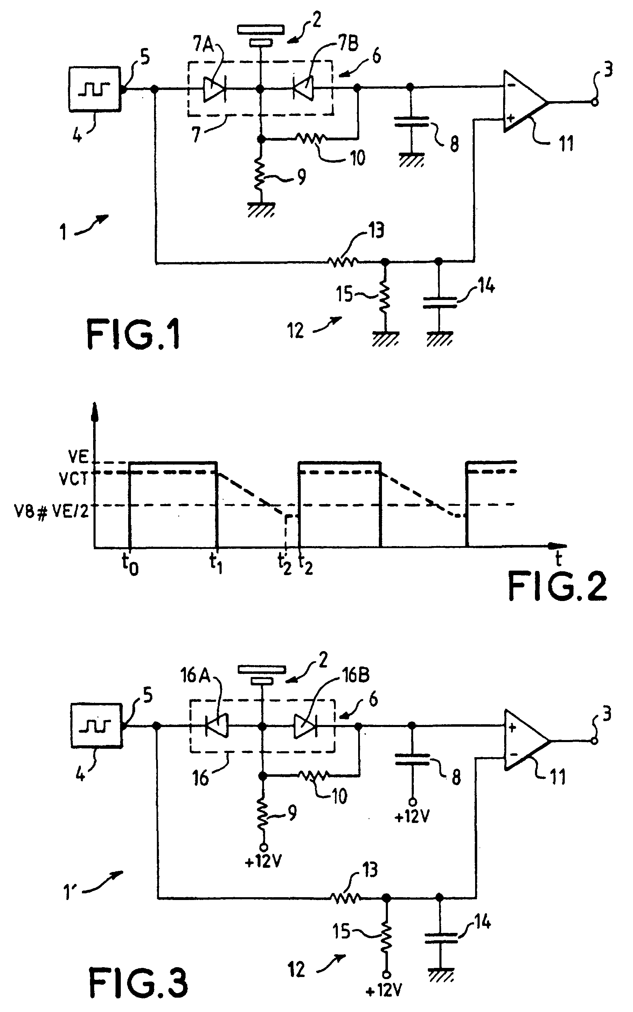

Le circuit de commande 1 représenté en figure 1 est destiné à produire un signal logique à deux états 0 et 1 dont l'un correspond à l'attouchement par l'utilisateur d'une touche capacitive 2, et dont l'autre correspond au non-attouchement de cette touche. Ce signal logique apparaît sur la borne de sortie 3 du circuit 1 et est exploité de façon classique par des circuits (non représentés) ne faisant pas partie de l'invention, de tout type approprié.

Le circuit 1 comprend un générateur 4 de tension périodique à valeur moyenne non nulle. Ce générateur est par exemple un microprocesseur.

De préférence, cette tension est une tension rectangulaire à rapport cyclique de 50 %. La borne de sortie 5 du générateur 4 est reliée à un circuit redresseur 6 comportant une diode double 7 en boîtier unique et un condensateur 8. La diode double 7 est composée de deux diodes 7A et 7B à cathode commune, qui sont ainsi reliées en série et en opposition. L'anode de la diode 7A est reliée à la borne 5, tandis que l'anode de la diode 7B est reliée au condensateur 8. Ces diodes 7A et 7B sont issues de la même tranche de matériau semi-conducteur ("wafer" en anglais), et sont encapsulées dans un boîtier commun. Elles sont ainsi appairées de par leur procédé de fabrication. Ce sont par exemple des diodes portant la dénomination BAV 70, dont l'autre avantage est d'être de faible coût. La cathode commune de la diode 7 est reliée à l'électrode active de la touche 2, et est d'autre part reliée à la masse par une résistance 9. Une résistance 10 est montée en parallèle sur la diode 7B. Les valeurs des résistances 9 et 10 sont avantageusement dans le rapport 1/2. La sortie du redresseur 6 est reliée à l'entrée (-) inverseuse d'un amplificateur opérationnel 11 dont la sortie est reliée à la borne 3. La borne 5 est par ailleurs reliée par un circuit intégrateur 12 à l'entrée (+) non inverseuse de l'amplificateur 11.

Ce circuit intégrateur 12 comporte une résistance série 13 suivie d'un condensateur 14 en dérivation mis en parallèle avec une résistance 15.

Dans un exemple de réalisation, les résistances 9, 10, 13 et 15 ont pour valeurs respectives 430 KΩ, 1 MΩ, 56 KΩ et 390 KΩ, et les condensateurs 8 et 14 ont pour valeur respectives 33 nF et 100 nF.

L'amplificateur 11 est un circuit intégré LM 339.

Le dispositif 1 décrit ci-dessus fonctionne de la façon suivante. Le signal produit par le générateur 4 est un signal rectangulaire périodique de période T. Au cours de la première partie de chaque période (par exemple entre t0 et t1 en figure 2), le signal passe de 0 à la valeur VE (à l'instant t0) et y reste jusqu'en t1. A l'instant t1, il repasse à zéro et reste nul jusqu'en t2. A l'instant t0, la tension aux bornes de condensateur CT constitué par la touche 2 passe quasi instantanément à la valeur Vct inférieure à VE, car l'impédance de CT est faible par rapport à celle de la diode 7A à travers laquelle CT se charge. La différence entre Vct et VE est surtout due à la chute de tension aux bornes de la diode 7A. A partir de l'instant t1, le condensateur CT se décharge à travers la résistance 9 et à travers le circuit constitué par la résistance 10 et le condensateur 8, et ce, jusqu'à une valeur minimale Vm, qui est stockée dans le condensateur 8. Aux bornes de ce condensateur 8, on recueille une tension dont la valeur est sensiblement égale à la valeur crête de la tension aux bornes du condensateur de touche CT. Lorsque l'utilisateur approche le doigt de la touche 2, la capacité CT augmente, ce qui fait augmenter la tension aux bornes de condensateur 8. Par ailleurs, la borne (+) de l'amplificateur 11 reçoit une tension qui est sensiblement égale à VE/2, car les éléments 13, 14 et 15 constituent un intégrateur qui produit à sa sortie la valeur moyenne de la tension fournie par le générateur 4. Si comme précisé ci-dessus, le rapport cyclique de la tension du générateur 4 est égal à 1/2 (c'est à dire que le laps de temps t0-t1 est égal à T/2), la valeur moyenne de la tension fournie par le générateur 4. est égale à VE/2. Le comparateur formé par l'amplificateur 11 reçoit donc sur son entrée (+) une tension continue fixe (égale à VE/2) qui peut être considérée comme tension de référence, et il reçoit sur son entrée (-) la tension qui est présente aux bornes du condensateur 8. Lorsque cette dernière augmente du fait de l'attouchement de la touche 2, comme précisé ci-dessus, cette augmentation est aussitôt détectée par le comparateur 11, dont l'état de sortie indique alors l'attouchement.

On peut déterminer la valeur de la tension V8 aux bornes du condensateur 8 de la façon suivante. Soient Vct la tension aux bornes du condensateur formé par la touche 2, V7A et V7B les tensions aux bornes des diodes 7A et 7B respectivement, R9, la valeur de la résistance 9, C8 la capacité du condensateur 8; on a alors :

$$V8 = Vct \text{ crête} + V7B,$$

avec :

$$Vct \text{ crête} = (VE-V7A) \cdot (1 - e^{T/R9 \cdot CT}),$$

ce qui est très peu différent de $(VE - V7A) \cdot (1 - T/R9 \cdot CT)$

Si on considère que V7A et V7B sont très petites devant VE, que (1 - T/R9CT) est peu différent de 1/2, que Vct crête varie peu par rapport à VE lorsque CT varie, et que les diodes 7A et 7B sont appairées, on a : V8 peu différent de VE/2, et le courant dans la diode 7A est pratiquement égal au double du courant dans la diode 7B ce qui fait que la tension aux bornes de la diode 7A est sensiblement égale au double de la tension aux bornes de la diode 7B, car les zones de fonctionnement de ces diodes sont situées dans la partie linéaire de leur caractéristique (le courant dans cette partie étant d'environ 25 μA dans l'exemple cité).

On obtient alors ; $V8 \# VE \cdot (T/R9CT)$

Cette tension, apparaissant aux bornes de condensateur 8 et caractéristique de l'état de la touche 2 (actionnée ou non), est alors indépendante des chutes de tension dans les diodes 7A, 7B. On notera que la résistance 23 permet l'écoulement du courant de décharge du condensateur 8 lorsque la diode 7B est bloquée, c'est à dire entre t'2 et t2 (voir figure 2), et l'on obtient ainsi un palier entre ces deux instants dans l'évolution de la tension Vct crête, permettant à 7B de conduire correctement.

Les capacités parasites des diodes 7A et 7B sont d'environ 1pF. Elles ont une relativement grande influence sur le fonctionnement du dispositif de commande étant donnée la faible capacité de la touche 2 et les faibles variations de cette capacité. Dans le dispositif de l'invention, la capacité parasite de la diode 7A intervient en tant qu'élément différentiateur des fronts de montée et de descente de la tension produite par le générateur 4, tandis que la capacité parasite de la diode 7B intervient en tant qu'élément intégrateur de cette tension, ce qui fait que leurs effets respectifs se compensent mutuellement. Ainsi, grâce à l'appairage des diodes, le dispositif de l'invention procure une bonne reproductibilité de ses caractéristiques, et en particulier de la sensibilité de la touche, qui est stable en fonction des variations de température ambiante.

Le générateur 4, peut être par exemple du type à diviseur à logique câblée ou un microprocesseur du type PWM (pour "Pulse Width Modulation" ou modulation de la largeur des impulsions). Sa fréquence est par exemple comprise entre 100 et 300 kHz. Le signal produit par un tel générateur est stable en fréquence (il est issu d'un oscillateur stabilisé à quartz), et par conséquent la sensibilité de la touche est stable (du fait que V8 est fonction, comme précisé ci-dessus, de la période de ce signal, et du fait que le rapport cyclique est également stable, car déterminé par la division par 2 d'une fréquence stable).

Les variations d'amplitude de la tension VE ne perturbent pas la sensibilité du dispositif, car la tension de référence, arrivant sur la borne (+) de l'amplificateur 11 est proportionnelle à VE : c'est en fait la valeur moyenne de VE qui arrive sur cette borne, c'est à dire VE/2 dans le cas présent, puisque le rapport cyclique est choisi égal à 1/2.

On a représenté en figure 3 le schéma d'une variante du dispositif de l'invention, mettant en oeuvre une diode double à anode commune, par exemple une diode BAW56. Sur cette figure, les éléments similaires à ceux de la figure 1 sont affectés des mêmes références numériques.

La diode double est référencée 16 dans son ensemble sur la figure 3, et elle est composée des diodes 16A et 16B, à anode commune. Du fait du changement de sens des diodes 16A et 16B par rapport aux diodes 7A, 7B, les éléments 8, 9 et 15 ne sont pas reliés à la masse, mais à une tension positive, par exemple égale à + VE (+ 12V dans le cas présent), et la sortie du circuit détecteur 6 est reliée à l'entrée (+) de l'amplificateur 11, son entrée (-) étant reliée à la sortie du circuit intégrateur 12. Le fonctionnement de ce circuit est le même que celui du circuit de la figure 1.

De façon avantageuse, le rapport cyclique de la tension rectangulaire produite par le générateur 4 peut dépendre (par programmation ou par asservissement) de différents facteurs externes tels que la température ou la matière dans laquelle est fabriqué le substrat de la touche capacitive (verre, vitrocéramique,...).

**Revendications**

**1.** Dispositif (1) de commande à touche sensitive alimenté par un générateur (4) de tension périodique, le générateur (4) étant relié à une première entrée d'un comparateur (11) par l'intermédiaire d'un circuit détecteur (6) à deux diodes (7A, 7B ou 16A, 16B), entre la sortie du générateur et ladite première entrée dudit comparateur (11), ce générateur étant par ailleurs relié à une deuxième entrée du comparateur par un circuit intégrateur (12) et produisant une tension périodique à valeur moyenne non nulle, **caractérisé en ce que** les deux diodes (7A, 7B ou 16A, 16B) sont appairées en série et en opposition et associées à un pont diviseur résistif (9, 10), ledit pont diviseur résistif (9, 10) étant relié entre la première entrée du comparateur et une borne de référence (masse), le point commun des deux résistances du pont diviseur étant relié au point commun des deux diodes, ce dernier étant relié à la touche sensitive (2).

**2.** Dispositif selon la revendication 1, **caractérisé par le fait que** les deux diodes font partie d'un même circuit intégré dit "monochip".

**3.** Dispositif selon la revendication 2, **caractérisé par le fait que** les deux diodes sont du type BAV70 ou BAW56.

**4.** Dispositif selon l'une des revendications précédentes, **caractérisé par le fait que** le pont diviseur (9, 10) est un pont diviseur par 2 qui impose aux bornes de la première diode (7A, 16A) une tension double de celle aux bornes de la seconde (7B, 16B).

**5.** Dispositif selon l'une des revendications précédentes, **caractérisé par le fait que** le générateur produit une tension rectangulaire.

**6.** Dispositif selon la revendication 5, **caractérisé par le fait que** la tension rectangulaire a un rapport cyclique de 1/2.

**7.** Dispositif selon la revendication 5, **caractérisé par le fait que** le rapport cyclique de la tension rectangulaire est fonction de facteurs externes.

**Claims**

**1.** Control device (1) with a sensitive key supplied by a periodic voltage generator (4), the generator (4) being connected to a first input of a comparator (11) by means of a detector circuit (6) with two diodes (7A, 7B or 16A, 16B), between the output of the generator and the said first input of the said comparator (11), this generator also being connected to a second input of the comparator by an integrating circuit (12) and producing a periodic voltage with a non-zero mean value, **characterised in that** the two diodes (7A, 7B or 16A, 16B) are paired in series and in opposition and associated with a resistive bridge divider (9, 10), the said resistive bridge divider (9, 10) being connected between the first input of the comparator and a reference terminal (earth), the common point of the two resistors of the divider bridge being connected to the common point of the two diodes, this being connected to the sensitive key (2).

2. Device according to Claim 1, **characterised by** the fact that the two diodes form part of the same so-called "monochip" integrated circuit.

3. Device according to Claim 2, **characterised by** the fact that the two diodes are of the BAV70 or BAW56 type.

4. Device according to one of the preceding claims, **characterised by** the fact that the bridge divider (9, 10) is a bridge divider dividing by two which imposes, at the terminals of the first diode (7A, 16A), a voltage which is double the one at the terminals of the second (7B, 16B).

5. Device according to one of the preceding claims, **characterised by** the fact that the generator produces a rectangular voltage.

6. Device according to Claim 5, **characterised by** the fact that the rectangular voltage has a cycle ratio of 1/2.

7. Device according to Claim 5, **characterised by** the fact that the cycle ratio of the rectangular voltage is a function of external factors.

**Patentansprüche**

1. Steuervorrichtung (1) mit berührungsempfindlicher Taste, die von einem Generator (4) zur Erzeugung einer periodischen Spannung gespeist ist, wobei der Generator (4) mit einem ersten Eingang eines Komparators (11) über eine Detektorschaltung (6) mit zwei Dioden (7A, 7B oder 16A, 16B) zwischen dem Ausgang des Generators und dem ersten Eingang des Komparators (11) verbunden ist, wobei dieser Generator im übrigen mit einem zweiten Eingang des Komparators über eine Integratorschaltung (12) verbunden ist und eine periodische Spannung mit einem von Null verschiedenen Mittelwert erzeugt, **dadurch gekennzeichnet, daß** die zwei Dioden (7A, 7B oder 16A, 16B) angepaßt sind und in Serie zueinander entgegengesetzt liegen, und mit einer Widerstandsteilerbrücke (9, 10) verbunden sind, wobei die Widerstandsteilerbrücke (9, 10) zwischen dem ersten Eingang des Komparators und einer Referenzklemme (Masse) angeschlossen ist und der gemeinsame Punkt der zwei Widerstände der Teilerbrücke mit dem gemeinsamen Punkt der zwei Dioden verbunden ist, wobei letzterer mit der berührungsempfindlichen Taste (2) verbunden ist.

2. Vorrichtung nach Anspruch 1, **dadurch gekennzeichnet, daß** die zwei Dioden Teil einer "Monochip" genannten gleichen integrierten Schaltung sind.

3. Vorrichtung nach Anspruch 1, **dadurch gekennzeichnet, daß** die zwei Dioden vom Typ BAV70 oder BAW56 sind.

4. Vorrichtung nach einem der vorhergehenden Ansprüche, **dadurch gekennzeichnet, daß** die Teilerbrücke (9, 10) eine Teilerbrücke durch 2 ist, die an die Klemmen der ersten Diode (7A, 16A) eine Spannung anlegt, die doppelt so groß wie die an den Klemmen der zweiten (7B, 16B) ist.

5. Vorrichtung nach einem der vorhergehenden Ansprüche, **dadurch gekennzeichnet, daß** der Generator eine Rechteckspannung erzeugt.

6. Vorrichtung nach Anspruch 5, **dadurch gekennzeichnet, daß** die Rechteckspannung ein zyklisches Verhältnis von ½ hat.

7. Vorrichtung nach Anspruch 5, **dadurch gekennzeichnet, daß** das zyklische Verhältnis der Rechteckspannung von externen Faktoren abhängt.

**FIG.1**

**FIG.2**

**FIG.3**